Europäisches Patentamt

European Patent Office

Office européen des brevets

(19)

(11) **EP 1 126 458 A1**

(12) **DEMANDE DE BREVET EUROPEEN**

(43) Date de publication:
**22.08.2001 Bulletin 2001/34**

(51) Int Cl.⁷: **G11B 20/10**, H03G 3/20,
G06F 3/16

(21) Numéro de dépôt: **01400378.4**

(22) Date de dépôt: **13.02.2001**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **16.02.2000 FR 0001905**

(71) Demandeur: **TOUCHTUNES MUSIC CORPORATION**
**Las Vegas, NV 89104 (US)**

(72) Inventeurs:
• **Nathan, Guy**
**Nun's Island, Quebec H3E 1H7 (CA)**
• **Dion, Dominique**
**Iles des Soeurs Verdun Quebec H3E 1M2 (CA)**

(74) Mandataire: **Debay, Yves**
**Cabinet Debay,**
**126 Elysée 2**
**78170 La Celle Saint Cloud (FR)**

(54) **Procédé d'ajustement du volume sonore d'un volume sonore numérique**

(57) La présente invention concerne un procédé d'ajustement du volume sonore d'un enregistrement sonore numérique caractérisé en ce qu'il comprend:

- une étape de détermination, en valeur absolue, pour un enregistrement de la valeur d'amplitude maximum pour les fréquences sonores audibles à l'oreille humaine,

- une étape du calcul du gain possible pour un réglage du niveau de son déterminé, entre la valeur de l'amplitude maximale précédemment déterminée et la valeur de l'amplitude maximale toutes fréquences confondues,

- une étape de restitution de l'enregistrement par une carte son en ajustant automatiquement le niveau de gain d'amplification permettant d'obtenir un niveau sonore de l'enregistrement d'une valeur déterminée pour qu'il corresponde au gain calculé pour cet enregistrement.

Fig. 1

EP 1 126 458 A1

**Description**

La présente invention concerne un procédé d'ajustement du volume sonore d'un enregistrement sonore numérique restitué par un équipement. Ce procédé est principalement destiné à être utilisé lors de la restitution d'un enregistrement numérique sous forme d'un fichier information par l'intermédiaire d'une carte son, par exemple d'un système de reproduction audiovisuel, tel qu'un juke-box.

Il est connu dans l'art antérieur que les enregistrements numériques, par exemple de type compact disque (CD), ne sont pas restitués avec le même volume sonore pour un niveau déterminé de réglage du son. Ceci est dû essentiellement au type de musique et à la façon dont a été enregistré le morceau de musique. En effet, une trame sonore est constituée d'un signal électrique présentant une succession d'oscillations et de crêtes. Chaque crête correspond à une valeur de voltage. Plus la valeur est importante en valeur absolue, plus le volume est important et plus la variation du signal s'effectue selon une pente élevée, plus la fréquence du son reproduit est haute. Lorsqu'un tel enregistrement est enregistré sous la forme d'un fichier numérique puis restitué sur un système de son par l'intermédiaire d'une carte son numérique d'un ordinateur, on observe les mêmes phénomènes de variation des maxima puisque les informations contenues dans le fichier sont sensiblement les mêmes que celles inscrites sur un CD. Par conséquent, entre deux enregistrements de types de musique différents, il est nécessaire de modifier le réglage du niveau sonore entre deux enregistrements, pour obtenir une restitution avec un niveau sonore identique pour deux enregistrements différents dont les niveaux sonores originaux sont différents.

La présente invention a donc pour objet de pallier les inconvénients de l'art antérieur en proposant un procédé d'ajustement du niveau sonore d'un enregistrement sonore numérique permettant d'obtenir un niveau sonore identique d'un enregistrement à l'autre, quelles que soient les différences de niveau d'enregistrement sonore numérique existant initialement entre chacun des enregistrements.

Ce but est atteint par le procédé d'ajustement du volume sonore d'un enregistrement numérique selon la revendication 1.

Des développements supplémentaires seront décrits dans les revendications 2 à 8.

Un deuxième but est atteint par le procédé d'ajustement automatique du volume selon les revendications 9 et 10.

D'autres particularités et avantages de la présente invention apparaîtront plus clairement à la lecture de la description ci-après faite en référence aux dessins annexés dans lesquels :

- la figure 1 représente un synoptique d'une carte son utilisant le procédé selon l'invention.

- les figures 2A et 2B représentent une courbe représentant la fréquence d'apparition d'une tension dans un enregistrement numérique,
- la figure 3 représente une trame sonore d'un enregistrement.

Avant d'entamer la description de l'invention, il convient de faire certains rappels sur l'enregistrement numérique. Tout d'abord, la reproduction de son par un haut-parleur consiste à appliquer à ce haut-parleur des tensions de niveaux déterminés, selon une fréquence déterminée pour faire vibrer une membrane et donc produire le son correspondant à la fréquence déterminée. Pour une valeur d'amplification donnée, la valeur de la tension efficace définit le volume du son ou niveau sonore.

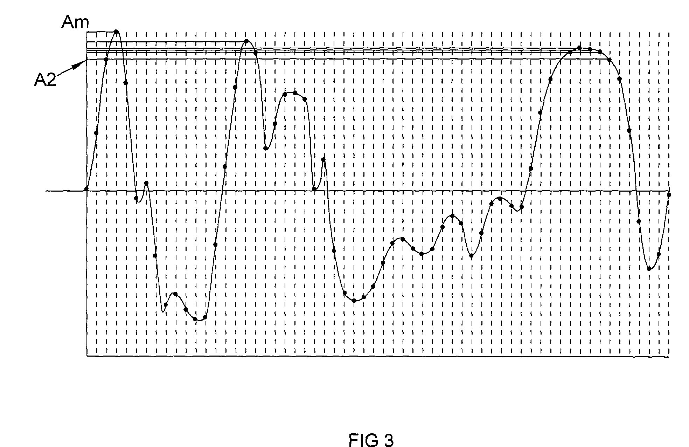

Une trame sonore, représentée figure 3, est donc constituée d'une superposition d'oscillations représentant les variations en fonction du temps de l'amplitude de la tension d'alimentation d'un élément de restitution acoustique tel qu'un haut parleur. La numérisation d'un enregistrement sonore consiste en fait à réaliser un échantillonnage de la trame sonore et donc à lire les valeurs de la tension selon des intervalles de temps déterminés par une périodicité. Plus la période est courte, plus la numérisation est précise. Lors de la restitution de l'enregistrement, le signal analogique est reconstruit à partir des échantillons digitaux conservés lors de la numérisation. Les points sur la courbe représentent les échantillons utilisés lors de la numérisation.

Ainsi, suivant le type de musique, la courbe (C) représentant la fréquence du son restitué, définie par la pente de la courbe (C) et la valeur des niveaux sonores maximum de tension correspondante, pour un même réglage des circuits d'amplification du son, le niveau de sortie des haut-parleurs sera différent. En effet, les tensions efficaces maximales observées pour un premier enregistrement ne seront pas forcément du même ordre que les tensions efficaces maximales observées pour un deuxième enregistrement. L'objet de l'invention est donc de résoudre cet inconvénient de sorte que, d'un enregistrement à l'autre, le volume ou le niveau sonore perçu par l'auditeur soit automatiquement ajusté pour que le niveau sonore soit identique d'un enregistrement à l'autre.

L'invention nécessite, d'une part une analyse préalable de chaque enregistrement susceptible d'être restitué sur un système de reproduction audiovisuelle ou sur un ordinateur et d'autre part, une correction du niveau d'amplification lors de la restitution sonore de l'enregistrement, en fonction de l'analyse.

Une première solution consisterait à rechercher, en valeur absolue, la tension maximum observée sur chaque enregistrement, et de se servir de cette valeur pour amplifier les enregistrements de sorte que, pour un réglage du niveau de son déterminé, cette valeur atteigne une même valeur de tension pour tous les enregistrements. Cependant, une trame sonore d'un enregistrement comprend à la fois des sons de fréquences audibles et des sons de fréquences inaudibles à l'oreille humaine. Ainsi, si l'amplitude maximum correspond à une fréquence inaudible, l'ajustement de volume ne sera pas adapté.

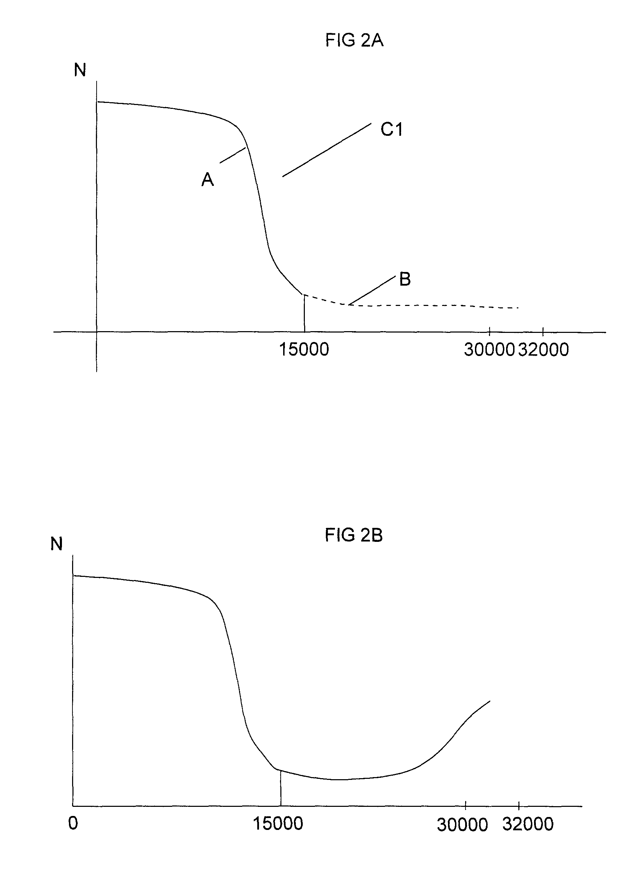

Le procédé selon l'invention consiste donc, dans une première étape, à déterminer pour un enregistrement, le maximum d'amplitude uniquement pour les fréquences audibles pour l'oreille humaine. Dans une première variante de réalisation, ce maximum d'amplitude est déterminé par une analyse de l'enregistrement numérique pour classer par ordre croissant d'amplitude, en valeur absolue, le nombre d'échantillons de l'enregistrement pour chaque amplitude. Ce classement est représenté figure 2A. L'axe des ordonnées représente le nombre N d'apparitions d'une amplitude déterminée dans l'enregistrement et l'axe des abscisses représente en valeur absolue le nombre représentant la tension en volt du signal analogique lors du codage numérique du signal analogique avec 16 bits de précision. Lors de la numérisation du signal analogique représentatif d'un signal sonore, chaque tension échantillonnée est codée avec un nombre compris entre -32767 et 32767 lorsque la précision est de 16 bits.

De façon empirique, on observe qu'un enregistrement correspondant à une chanson, ne comprend que quelques échantillons, de l'ordre d'une dizaine, situés sur la portion (B) de la courbe (C1), ayant les amplitudes les plus élevées dans l'enregistrement. Ainsi, la portion (B) de la courbe (C1) est représentée en pointillés afin de montrer que toutes les valeurs des nombres représentant les tensions du signal analogique correspondant ne sont pas représentées. De même, on observe que 90% des échantillons d'un enregistrement ont une faible amplitude, c'est-à-dire situés sur la portion (A) de la courbe C1.

Selon l'invention, l'amplitude maximum est choisie, dans le classement réalisé, comme étant l'amplitude inférieure de n rangs par rapport au rang de l'échantillon d'amplitude maximum de l'enregistrement. En d'autres termes, si 1 correspond au rang du nombre représentatif de l'amplitude apparaissant le plus grand nombre de fois dans l'enregistrement et K est le rang du nombre représentant l'amplitude maximale trouvée sur l'enregistrement numérique, alors l'amplitude choisie comme amplitude maximale pour le procédé correspond au nombre de rang K-n, parmi le classement établi et correspondant à la courbe (C1). Ainsi, on ne prend pas en compte les n-1 échantillons, situés sur la portion B de la courbe (C1), en partant de l'amplitude maximum, ce qui signifie que ces échantillons n'apparaîtront pas dans la restitution finale. Ensuite, la correction de volume de l'enregistrement, c'est-à-dire le gain en volume Gv possible pour l'enregistrement est déterminé en appliquant la formule suivante :

$$Gv = 20\log(A_2/Am) \qquad (a)$$

Dans cette formule, $A_2$ est l'amplitude choisie et Am est l'amplitude maximum de l'enregistrement.

Dans la pratique, plus la valeur de n est importante, plus la qualité de la restitution de l'enregistrement est dégradée. En effet, plus n est important, plus le nombre d'échantillons d'amplitude élevée qui ne seront pas pris en compte sera important, et plus il est probable que les échantillons non pris en compte correspondront à des signaux audibles. Par conséquent, lorsque le gain calculé par la formule ci-dessus sera appliqué à l'enregistrement, certaines fréquences de sons seront trop amplifiées, ce qui se traduira par un phénomène de saturation au niveau des haut-parleurs et donc par une dégradation de la qualité de restitution. Il a été observé qu'une valeur de n de l'ordre de 10, et préférentiellement choisie égale à 4 ou 5, n'entraîne pas de dégradation perceptible lors de la restitution de l'enregistrement après application du gain calculé par la formule ci-dessus. Cette variante ne peut être appliquée de façon efficace que pour des enregistrements numériques qui n'ont pas subi de compression ou de traitement préalable visant à optimiser le niveau du volume.

A partir du classement réalisé précédemment une autre variante de détermination de la valeur de l'amplitude choisie peut être réalisée. Selon cette variante, la valeur de l'amplitude choisie correspond à la valeur moyenne $A_{moy}$ des n' plus grandes amplitudes apparaissant au moins k' fois dans l'enregistrement. Ensuite, la valeur du gain en volume Gv possible pour l'enregistrement est déterminée en appliquant la formule (a) ci-dessus en remplaçant $A_2$ par $A_{moy}$.

L'expérience a montré qu'en choisissant n' égal à 2 et k' égal à 4, la restitution de l'enregistrement sonore ne présentait pas de dégradation audible à l'oreille humaine. Plus n' et k' sont grands plus la restitution de l'enregistrement sonore est dégradée.

La figure 2B représente le résultat du classement réalisé sur un enregistrement ayant subi un traitement visant à optimiser le niveau sonore. En effet, les enregistrements ayant subi ce type de traitement prennent déjà en considération la présence de fréquences inaudibles et tendent à éliminer ces fréquences inaudibles au profit d'une meilleure gestion du volume de l'enregistrement. Pour ces enregistrements particuliers ayant subi un traitement pour optimiser le volume, le nombre d'échantillons ayant une valeur d'amplitude importante est plus élevé, de plus ces amplitudes correspondent à des signaux audibles. Par conséquent, l'étape précédemment décrite est applicable mais entraîne une dégradation perceptible de la restitution de l'enregistrement.

Pour les enregistrements ayant subi un traitement d'optimisation, l'étape de détermination de l'amplitude maximum pour les signaux audibles consiste à compresser l'enregistrement selon un procédé de compression utilisant au moins un masque psycho-acoustique permettant de supprimer les sons inaudibles de l'enregistrement. A titre d'exemple, il est possible d'utiliser le procédé connu MPEG-1 Layer 3 ou tout autre procédé de compression tel que AAC. En effet, il est connu que le procédé de compression MPEG utilise des masques pour éliminer de l'enregistrement toutes informations inutiles. Parmi les informations inutiles d'un enregistrement sonore, il y a toutes les fréquences inaudibles et toutes les variations de son qui ne sont pas perceptibles à l'oreille humaine. Ensuite l'enregistrement est décompressé et la valeur de l'amplitude maximale est recherchée dans cet enregistrement décompressé. Ainsi, lors de la décompression, l'enregistrement décompressé ne contient que des sons de fréquences audibles. En recherchant l'amplitude maximum dans cet enregistrement décompressé, on obtient nécessairement une amplitude maximum Am pour une fréquence audible. Dans cette variante de réalisation, il convient également de mémoriser avant la compression, l'amplitude maximum de l'enregistrement, toutes fréquences confondues, afin de pouvoir calculer le gain selon la formule (a). Cette deuxième variante de réalisation peut être appliquée à tout type d'enregistrement, puisque le procédé de compression MPEG est indifférent au type de l'enregistrement initial.

La valeur du gain calculé par l'intermédiaire de la formule (a) est ensuite mémorisée avec l'enregistrement sonore réalisé, par exemple, sur un serveur ou sur le système de reproduction audiovisuelle, et utilisée lors de la restitution de l'enregistrement par le système de restitution. En effet, lors de la restitution de l'enregistrement numérique initial, le gain calculé pour cet enregistrement est ajouté lors du réglage du son.

Le procédé selon l'invention est utilisé notamment lorsque les enregistrements numériques sont restitués par l'intermédiaire d'une carte son d'un ordinateur ou d'un système de reproduction d'informations audiovisuelles. Le procédé selon l'invention nécessite donc d'avoir déterminé le gain soit arbitrairement soit par une analyse préalable de chaque enregistrement numérique susceptible d'être restitué par la carte son. Comme décrit précédemment, cette analyse consiste à déterminer le gain pouvant être appliqué à chaque enregistrement lors de sa restitution. Ce gain est, par exemple, mémorisé dans une base de données sur des moyens de mémorisation de l'ordinateur ou du système de reproduction et est accessible par le programme de gestion de la carte son, de sorte que chaque enregistrement mémorisé sur les moyens de mémorisation de l'ordinateur ou du système de reproduction est associé à un gain dans la base de données. Ainsi, avant la restitution d'un enregistrement déterminé, le programme de gestion de la carte son consulte la base de données et collecte l'information représentative du gain calculé pour cet enregistrement. Lors du réglage du son de cet enregistrement, le niveau choisi par l'utilisateur sera automatiquement ajusté d'une valeur correspondant au gain Gv calculé, de sorte que le niveau sonore réel corresponde effectivement au niveau choisi par l'utilisateur et qu'il soit homogène pour tous les enregistrements contenus dans les moyens de mémorisation. L'ajustement peut se faire en valeur positive ou négative.

Une autre variante du procédé selon l'invention consiste à ajuster le gain pour les signaux sonores d'un enregistrement correspondant aux graves et/ou aux aigus. L'objectif du procédé est d'augmenter, lorsque cela est possible, le gain pour les sons graves et/ou aigus sans dépasser le niveau sonore choisi par l'utilisateur et sans dépasser un gain maximum fixé pour les sons graves et/ou aigus. Il faut comprendre que dans cette variante, seuls les sons graves et/ou aigus sont concernés par l'ajustement dynamique du gain, lorsque le système de reproduction permet de régler indépendamment le niveau sonore général et le niveau sonore des sons graves et/ou aigus. Ainsi, lorsque le niveau sonore des sons graves et/ou aigus est inférieur au niveau sonore choisi par l'utilisateur, on autorise un gain supplémentaire sur les sons graves et/ou aigus pour augmenter la perception des sons graves et/ou aigus et améliorer la qualité de restitution de l'enregistrement. Ce gain supplémentaire sera au maximum égal au gain demande par l'utilisateur pour les sons graves et/ou aigus.

Le volume maximum est obtenu lorsque le signal entrant sur l'amplificateur n'est pas atténué, c'est à dire a un gain de 0 dB. Afin d'obtenir systématiquement un gain pour les graves et/ou les aigus, le volume maximum global pour l'enregistrement peut être inférieur à zéro dB et le volume maximum des graves et/ou des aigus est détermine pour que le gain entrant dans l'amplificateur puisse être égal à zéro dB. Par conséquent, il est toujours possible d'avoir un gain pour les graves et/ou les aigus correspondant à la valeur absolue de l'atténuation du volume de l'enregistrement. Ainsi, à titre d'exemple, si l'atténuation du volume de l'enregistrement est de -3dB, le gain pour les graves et/ou pour les aigus est de 3dB. Afin de limiter l'influence de l'ajustement dynamique des graves et/ou des aigus, le gain maximum des graves et/ou aigus est plafonné, par exemple à 12 dB. Ainsi, même si pour un volume déterminé le gain pour les graves et/ou les aigus peut être, par exemple de 16dB, celui-ci ne sera que de 12dB.

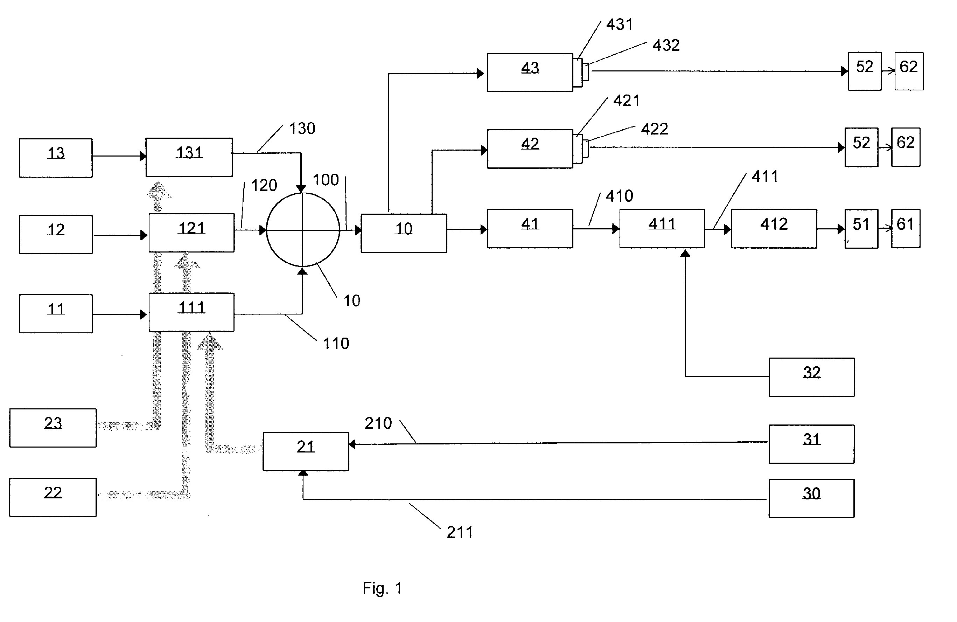

A titre d'exemple, la figure 1 représente un synoptique d'une carte son utilisant le procédé selon l'invention. Cette carte son est connectée, par exemple, à une unité centrale (non représentée) d'un ordinateur ou d'un système de reproduction comprenant, notamment, des moyens de mémorisation dans lesquels est stocké, notamment un programme de gestion, ou pilote, de la carte son. La carte son représentée figure 1 comprend, par exemple, 3 entrées (11, 12, 13). Une première entrée (11) reçoit les signaux représentatifs des enregistrements, par exemple, au travers d'un décodeur MPEG, la deuxième entrée (12) reçoit les signaux d'une source auxiliaire et la troisième entrée (13) reçoit les signaux provenant d'un microphone. Les signaux provenant des différentes entrées sont convertis, si nécessaire, en signaux numériques. Ensuite, le programme de gestion de la carte son affecte à chaque entrée (11, 12, 13), par l'intermédiaire d'un premier circuit de traitement (111, 121, 131), un gain (21, 22, 23) correspondant à celui mémorisé dans la base de données de l'unité centrale en association avec l'enregistrement réalisé. Pour l'entrée micro (13) et l'entrée de la source auxiliaire (12), il s'agit d'un gain (22, 23) prédéfini et fixé en fonction des caractéristiques du microphone et de la source auxiliaire. Pour l'entrée (11) recevant les signaux correspondant aux enregistrements, le programme de gestion de la carte son collecte, dans la base de données (30) mémorisée dans l'unité centrale, le gain calculé selon la formule (a) pour l'enregistrement arrivant sur la première entrée et un gain (31) prenant en compte par exemple l'utilisation d'un décodeur MPEG. Ces deux gains sont ensuite appliqués aux entrées (210, 211) d'un circuit additionneur (21) dont la sortie est connectée au premier circuit (111) de traitement associé à l'entrée (11) du décodeur MPEG. Les trois signaux (110, 120, 130) ainsi modifiés sont ensuite additionnés et mixés par un additionneur de signaux (20), pour former un seul signal (100). Ce signal (100) est ensuite atténué par un circuit électronique atténuateur (10) d'une valeur fixe déterminée. En effet, si les niveaux sonores des signaux d'entrée (110, 120, 130) sont tous proches du niveau sonore choisi par l'utilisateur, alors la somme de ces signaux va nécessairement dépasser ce niveau maximum choisi par l'utilisateur, d'où la nécessité de réduire systématiquement le niveau sonore du signal résultant de la somme des trois signaux (110, 120, 130) afin que, dans le cas le plus défavorable, il ne soit pas supérieur au niveau maximum choisi par l'utilisateur. Le signal (100) est ensuite affecté à au moins une zone, par exemple trois. Par zone, il faut comprendre un lieu équipé d'au moins un haut-parleur (61, 62, 63) connecté, à la carte son par l'intermédiaire d'un amplificateur (51, 52, 53). Pour chaque zone, le niveau sonore du signal est modifié en fonction du niveau sonore maximum choisi par l'utilisateur pour chacune de ces zones. Pour ce faire, le niveau maximum choisi par l'utilisateur pour chaque zone est préalablement mémorisé, par exemple, dans une base de données de l'unité centrale, puis lors de la restitution, collecté par le programme de gestion de la carte son et transmis à un circuit (41, 42, 43) atténuateur associé à chaque zone. Ensuite, le signal (410) ainsi modifié en fonction du réglage de chaque zone peut être modifié à nouveau par un gain dynamique (411, 421, 431) affecté aux graves et/ou aux aigus, tel que décrit précédemment. Pour ce faire, le programme de gestion de la carte son affecte un gain aux signaux de graves et/ou d'aigus contenus dans le signal de sortie de chaque zone. Ce gain correspond à l'atténuation appliquée au signal de sortie de chaque zone. En d'autres termes, si le signal de sortie d'une zone est atténué, par exemple de 6dB, pour ne pas dépasser le niveau sonore choisi par l'utilisateur, les signaux de graves et/ou d'aigus seront augmentés de 6dB. L'atténuation affectée à chaque zone est collectée par le programme de gestion de la carte son dans une base de donnée (32) ou un fichier spécifique mémorisé dans l'unité centrale.

Une fois l'ajustement dynamique des graves et/ou des aigus effectué, le signal numérique (4110) est appliqué à l'entrée d'un convertisseur (412, 422, 423) numérique/analogique dont la sortie est reliée à l'entrée d'un amplificateur (51, 52, 53) sur lequel sont connectés des haut-parleurs (61, 62, 63).

On conçoit que le procédé selon l'invention permet, après détermination préalable du gain en volume possible pour chaque enregistrement, de restituer tous les enregistrements numériques analysés, avec le même niveau sonore, pour un même réglage du son choisi par un utilisateur.

Un premier but est atteint par le fait que le procédé comprend :

- une étape de détermination, en valeur absolue, pour un enregistrement de la valeur d'amplitude maximum pour les fréquences sonores audibles à l'oreille humaine,
- une étape du calcul du gain possible pour un réglage de niveau de son déterminé, entre la valeur de l'amplitude maximum précédemment déterminée et la valeur de l'amplitude maximale toutes fréquences confondues,
- une étape de restitution de l'enregistrement par une carte son en ajustant automatiquement le niveau de gain d'amplification permettant d'obtenir un niveau sonore de l'enregistrement d'une valeur déterminée pour qu'il corresponde au gain calculé pour cet enregistrement.

Selon une autre particularité, l'étape de détermination de la valeur d'amplitude maximum comprend :

- une étape de comptage du nombre d'échantillons de l'enregistrement ayant une amplitude déterminée et ceci pour toutes les amplitudes existantes dans l'enregistrement,
- une étape de classement dans l'ordre croissant des amplitudes du nombre d'échantillons trouvés,
- une étape de mémorisation de l'amplitude maximum, toutes fréquences confondues, et de l'amplitude dont le numéro d'ordre dans le classement réalisé est inférieur de n rangs par rapport au rang de l'amplitude maximum, l'amplitude trouvée correspondant alors à l'amplitude maximum pour les fréquences audibles à l'oreille humaine.

Selon une autre particularité, n est déterminé pour que la dégradation de la qualité de la restitution de l'enregistrement ne soit pas perceptible à l'oreille humaine.

Selon une autre particularité, n est de l'ordre de 10 et de préférence égal à 4 ou 5.

Selon une autre particularité, l'étape de détermination de la valeur d'amplitude maximum comprend :

- une étape de comptage du nombre d'échantillons de l'enregistrement ayant une amplitude déterminée et ceci pour toutes les amplitudes existantes dans l'enregistrement,
- une étape de classement dans l'ordre croissant des amplitudes du nombre d'échantillons trouvés,
- une étape de calcul de la valeur moyenne Amoy des n' plus grandes amplitudes apparaissant au moins k' fois dans l'enregistrement.

Selon une autre particularité, l'étape de détermination de la valeur d'amplitude maximum comprend :

- une étape de compression de l'enregistrement par l'intermédiaire d'au moins un masque psycho-acoustique permettant de supprimer de l'enregistrement initial les sons inaudibles,
- une étape de décompression de l'enregistrement,
- une étape de recherche de l'amplitude maximum sur l'enregistrement décompressé, cette amplitude correspondant alors à l'amplitude maximum pour les fréquences audibles à l'oreille humaine.

Selon une autre particularité, le ou les masques psycho-acoustiques sont mis en oeuvre par le procédé de compression MPEG-1 Layer 3.

Selon une autre particularité, l'étape de restitution comprend une étape d'ajustement dynamique des niveaux sonores de restitution de l'enregistrement consistant à autoriser un gain déterminé pour les sons graves et/ou aigus de l'enregistrement, le gain correspondant sensiblement à l'atténuation affectée lors de la restitution de l'enregistrement.

Un autre but de l'invention consiste en une utilisation du procédé selon l'invention dans un système de reproduction audiovisuel, tel qu'un juke-box numérique.

Ce but est atteint par le fait que le procédé d'ajustement automatique du volume est utilisé sur un système de reproduction audiovisuelle numérique, cette utilisation étant caractérisée en ce que l'enregistrement est mémorisé dans le système de reproduction avec le gain calculé correspondant et des moyens de lecture du système de reproduction audiovisuelle accèdent à la valeur du gain pour commander les circuits de gain du processeur du traitement de signaux digitaux du système de reproduction audiovisuel numérique pour ajuster le niveau sonore en conséquence.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration, mais peuvent être modifiés dans le domaine défini par la portée des revendications jointes, et l'invention ne doit pas être limitée aux détails donnés ci-dessus.

**Revendications**

1. Procédé d'ajustement du volume sonore d'un enregistrement sonore numérique caractérisé en ce qu'il comprend :

- une étape de détermination, en valeur absolue, pour un enregistrement de la valeur d'amplitude maximum pour les fréquences sonores audibles à l'oreille humaine,

- une étape du calcul du gain possible pour un réglage du niveau de son déterminé, entre la valeur de l'amplitude maximale précédemment déterminée et la valeur de l'amplitude maximale toutes fréquences confondues,

- une étape de restitution de l'enregistrement par une carte son en ajustant automatiquement le niveau de gain d'amplification permettant d'obtenir un niveau sonore de l'enregistrement d'une valeur déterminée pour qu'il corresponde au gain calculé pour cet enregistrement.

2. Procédé d'ajustement du volume selon la revendication 1, caractérisé en ce que l'étape de détermination de la valeur d'amplitude maximum comprend :

- une étape de comptage du nombre d'échantillons de l'enregistrement ayant une amplitude déterminée et ceci pour toutes les amplitudes existantes dans l'enregistrement,

- une étape de classement dans l'ordre croissant des amplitudes du nombre d'échantillons trouvés,

- une étape de mémorisation de l'amplitude maximum, toutes fréquences confondues, et de l'amplitude dont le numéro d'ordre dans le classement réalisé est inférieur de n rangs par rapport au rang de l'amplitude maximum, l'amplitude trouvée correspondant alors à l'amplitude maximum pour les fréquences audibles à l'oreille humaine.

3. Procédé d'ajustement du volume selon la revendication 2, caractérisé en ce que n est déterminé pour que la dégradation de la qualité de la restitution de l'enregistrement ne soit pas perceptible à l'oreille humaine.

4. Procédé d'ajustement du volume selon la revendication 2 ou 3, caractérisé en ce que, n est de l'ordre de 10 et de préférence égal à 4 ou 5.

5. Procédé d'ajustement du volume selon la revendication 1, caractérisé en ce que l'étape de détermination de la valeur d'amplitude maximum comprend :

   - une étape de comptage du nombre d'échantillons de l'enregistrement ayant une amplitude déterminée et ceci pour toutes les amplitudes existantes dans l'enregistrement,

   - une étape de classement dans l'ordre croissant des amplitudes du nombre d'échantillons trouvés,

   - une étape de calcul de la valeur moyenne $A_{moy}$ des n' plus grandes amplitudes apparaissant au moins k' fois dans l'enregistrement.

6. Procédé d'ajustement du volume selon la revendication 1, caractérisé en ce que l'étape de détermination de la valeur d'amplitude maximum comprend :

   - une étape de compression de l'enregistrement par l'intermédiaire d'au moins un masque psycho-acoustique permettant de supprimer de l'enregistrement initial les sons inaudibles,

   - une étape de décompression de l'enregistrement,

   - une étape de recherche de l'amplitude maximum sur l'enregistrement décompressé, cette amplitude correspondant alors à l'amplitude maximum pour les fréquences audibles à l'oreille humaine.

7. Procédé d'ajustement du volume selon la revendication 6, caractérisé en ce que le ou les masques psycho-acoustiques sont mis en oeuvre par un procédé de compression, par exemple, de type MPEG-1 Layer 3 ou AAC.

8. Procédé d'ajustement du volume selon l'une des revendications 1 à 7, caractérisé en ce que l'étape de restitution comprend une étape d'ajustement dynamique des niveaux sonores de restitution de l'enregistrement consistant à autoriser un gain déterminé pour les sons graves et/ou aigus de l'enregistrement, le gain correspondant sensiblement à l'atténuation affectée lors de la restitution de l'enregistrement.

9. Utilisation du procédé d'ajustement automatique du volume selon l'une des revendications 1 à 8, sur un système de reproduction audiovisuelle numérique caractérisée en ce que l'enregistrement est mémorisé dans le système de reproduction avec le gain calculé correspondant et des moyens de lecture du système de reproduction audiovisuelle accèdent à la valeur du gain pour commander les circuits de gain du processeur du traitement de signaux digitaux du système de reproduction audiovisuel numérique pour ajuster le niveau sonore en conséquence

10. Dispositif d'ajustement du volume, caractérisé en ce qu'il comporte des moyens d'ajustement dynamique des niveaux sonores de restitution de l'enregistrement prenant en compte un gain déterminé pour les sons graves et/ou aigus de l'enregistrement et le gain correspondant sensiblement à l'atténuation déterminée à affecter lors de la restitution de l'enregistrement pour évaluer le gain en entrée de l'amplificateur.

Fig. 1

## FIG 2A

## FIG 2B

FIG 3

EP 1 126 458 A1

**Office européen des brevets**

**RAPPORT DE RECHERCHE EUROPEENNE**

Numéro de la demande

EP 01 40 0378

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | EP 0 480 558 A (PIONEER ELECTRONIC CORP) 15 avril 1992 (1992-04-15) * colonne 1, ligne 8 - ligne 55 * * colonne 3, ligne 31 - colonne 4, ligne 19 * * colonne 5, ligne 44 - colonne 6, ligne 34 * --- | 1,8-10 | G11B20/10 H03G3/20 G06F3/16 |
| A | US 4 926 485 A (YAMASHITA MASAYASU) 15 mai 1990 (1990-05-15) * abrégé; figures 1,4,5 * * colonne 1, ligne 30 - ligne 62 * * colonne 2, ligne 14 - colonne 3, ligne 13 * * colonne 3, ligne 38 - colonne 4, ligne 4 * * revendications 1,7-10 * --- | 1,8-10 | |
| A | PATENT ABSTRACTS OF JAPAN vol. 007, no. 017 (E-154), 22 janvier 1983 (1983-01-22) & JP 57 173207 A (SONY KK), 25 octobre 1982 (1982-10-25) * abrégé * --- | 1,8-10 | |
| A | PATENT ABSTRACTS OF JAPAN vol. 1998, no. 09, 31 juillet 1998 (1998-07-31) & JP 10 098344 A (SONY CORP), 14 avril 1998 (1998-04-14) * abrégé * --- | 1,10 | **DOMAINES TECHNIQUES RECHERCHES (Int.Cl.7)** G11B H03G G06F |
| A | EP 0 363 186 A (PIONEER ELECTRONIC CORP) 11 avril 1990 (1990-04-11) * abrégé * * page 2, ligne 29 - ligne 54 * * page 4, ligne 10 - page 5, ligne 14 * * page 7, ligne 36 - page 8, ligne 1 * --- -/-- | 1,2,5, 8-10 | |

Le présent rapport a été établi pour toutes les revendications

| Lieu de la recherche | Date d'achèvement de la recherche | Examinateur |
|---|---|---|
| LA HAYE | 29 mai 2001 | Schiwy-Rausch, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

11

Office européen
des brevets

**RAPPORT DE RECHERCHE EUROPEENNE**

Numéro de la demande

EP 01 40 0378

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | PATENT ABSTRACTS OF JAPAN vol. 1997, no. 02, 28 février 1997 (1997-02-28) & JP 08 279235 A (SHARP CORP), 22 octobre 1996 (1996-10-22) --- | | |
| A | EP 0 283 304 A (MATSUSHITA ELECTRIC IND CO LTD) 21 septembre 1988 (1988-09-21) ----- | | |

DOMAINES TECHNIQUES RECHERCHES (Int.Cl.7)

Le présent rapport a été établi pour toutes les revendications

| Lieu de la recherche | Date d'achèvement de la recherche | Examinateur |
|---|---|---|
| LA HAYE | 29 mai 2001 | Schiwy-Rausch, G |

## ANNEXE AU RAPPORT DE RECHERCHE EUROPEENNE
## RELATIF A LA DEMANDE DE BREVET EUROPEEN NO.

EP 01 40 0378

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

29-05-2001

| Document brevet cité au rapport de recherche | | Date de publication | Membre(s) de la famille de brevet(s) | | | Date de publication |
|---|---|---|---|---|---|---|
| EP 0480558 | A | 15-04-1992 | JP | 4150106 | A | 22-05-1992 |
| | | | DE | 69128906 | D | 19-03-1998 |
| | | | DE | 69128906 | T | 30-07-1998 |
| | | | US | 5195075 | A | 16-03-1993 |
| US 4926485 | A | 15-05-1990 | JP | 1231510 | A | 14-09-1989 |
| | | | JP | 1967012 | C | 18-09-1995 |
| | | | JP | 6091394 | B | 14-11-1994 |
| JP 57173207 | A | 25-10-1982 | JP | 1010124 | B | 21-02-1989 |
| | | | JP | 1530469 | C | 15-11-1989 |
| JP 10098344 | A | 14-04-1998 | AUCUN | | | |
| EP 0363186 | A | 11-04-1990 | JP | 2098871 | A | 11-04-1990 |
| | | | JP | 2098887 | A | 11-04-1990 |
| | | | JP | 2098888 | A | 11-04-1990 |
| | | | DE | 68911829 | D | 10-02-1994 |
| JP 08279235 | A | 22-10-1996 | AUCUN | | | |
| EP 0283304 | A | 21-09-1988 | JP | 2687340 | B | 08-12-1997 |
| | | | JP | 63231784 | A | 27-09-1988 |
| | | | CN | 88101865 | A,B | 05-10-1988 |
| | | | DE | 3882257 | A | 19-08-1993 |
| | | | DE | 3882257 | T | 28-10-1993 |
| | | | KR | 9200420 | B | 13-01-1992 |
| | | | US | 5008872 | A | 16-04-1991 |

EPO FORM P0460

Pour tout renseignement concernant cette annexe : voir Journal Officiel de l'Office européen des brevets, No.12/82